# EUROPEAN PATENT APPLICATION

(11) **EP 4 390 749 A1**
(43) Date of publication of application: **26.06.2024**
(21) Application number: 23864158.3
(22) Date of filing: 23.05.2023
(51) Int. Cl.: G06F 30/392

(54) **METHOD AND APPARATUS FOR AIR BRIDGE ARRANGEMENT IN CIRCUIT LAYOUT, DEVICE, MEDIUM, AND PRODUCT**

(30) Priority: 31.10.2022 CN 202211351553
(71) Applicant: Tencent Technology (Shenzhen) Company Limited, Shenzhen, Guangdong, 518057 (CN)
(72) Inventor: MA, Shengming, Shenzhen, Guangdong 518057 (CN); HU, An, Shenzhen, Guangdong 518057 (CN); ZHANG, Tianyu, Shenzhen, Guangdong 518057 (CN); HUAI, Sainan, Shenzhen, Guangdong 518057 (CN); ZHANG, Shengyu, Shenzhen, Guangdong 518057 (CN); HUANG, Zhao, Shenzhen, Guangdong 518057 (CN); XU, Xiong, Shenzhen, Guangdong 518057 (CN); LI, Yanghepu, Shenzhen, Guangdong 518057 (CN)
(74) Representative: Nederlandsch Octrooibureau
(86) International application number: PCT/CN2023/095676
(87) International publication number: WO 2024/093205

(57) **Abstract**

An air bridge deployment method and apparatus in a circuit layout, a device, a medium, and a product are provided, and in particular, relate to the field of chip technologies. The method includes: obtaining position information of skeleton lines of CPW lines based on position information of the CPW lines in the circuit layout, each skeleton line being a center line of a respective CPW line (320); obtaining an interweave pair from the skeleton lines of the CPW lines based on the position information of the skeleton lines of the CPW lines, the interweave pair including two interweaved skeleton lines (330); and deploying air bridges on the circuit layout along the skeleton lines, and the air bridges on the two skeleton lines in the interweave pair being arranged in a staggered manner (340). According to the foregoing solution, impacts between air bridges on different CPW lines are reduced, and a success rate of subsequent circuit fabrication is improved.

## Description

### RELATED APPLICATION

This application claims priority to Chinese Patent Application No. 202211351553.2, filed on October 31, 2022 and entitled "AIR BRIDGE DEPLOYMENT METHOD AND APPARATUS IN CIRCUIT LAYOUT, DEVICE, MEDIUM, AND PRODUCT", which is incorporated herein by reference in its entirety.

### FIELD OF THE TECHNOLOGY

Embodiments of this application relate to the field of chip technologies, and in particular, to an air bridge deployment method and apparatus in a circuit layout, a device, a medium, and a product.

### BACKGROUND OF THE DISCLOSURE

The asymmetry, discontinuity and bending of a coplanar waveguide (CPW) in a superconducting quantum chip may produce a parasitic mode in a circuit and affect line transmission characteristics. The most commonly used method to suppress the parasitic modes in the CPW is to deploy air bridges along the CPW.

In the related art, an air bridge deployment method is provided, and air bridges may be deployed along skeleton lines of CPW lines. According to the method, a series of air bridges are deployed along the CPW lines based on coordinate information of the skeleton lines of the CPW lines.

Due to the size of a chip circuit and the limitation of the layout space, in a case that the foregoing solution is used to deploy air bridges, there may be a problem that air bridges on two close CPW lines are also close to each other, and this affects a success rate of subsequent circuit chip preparation.

### SUMMARY

Embodiments of this application provide an air bridge deployment method and apparatus in a circuit layout, a device, a medium, and a product. The technical solutions are as follows:

According to an aspect of embodiments of this application, an air bridge deployment method in a circuit layout is provided, executable by a computer device, the method including:
obtaining position information of skeleton lines of coplanar waveguide (CPW) lines based on position information of the CPW lines in the circuit layout, each of the skeleton lines being a center line of a respective CPW line;
obtaining an interweave pair from the skeleton lines of the CPW lines based on the position information of the skeleton lines of the CPW lines, the interweave pair including two interweaved skeleton lines; and
deploying air bridges on the circuit layout along the skeleton lines, and the air bridges on the two skeleton lines in the interweave pair being arranged in a staggered manner.

According to an aspect of embodiments of this application, an air bridge deployment apparatus in a circuit layout is provided, including:
a second position obtaining module, configured to obtain position information of skeleton lines of coplanar waveguide (CPW) lines based on position information of the CPW lines in the circuit layout, each of the skeleton lines being a center line of a respective CPW line;
an interweave pair obtaining module, configured to obtain an interweave pair from the skeleton lines of the CPW lines based on the position information of the skeleton lines of the CPW lines, the interweave pair including two interweaved skeleton lines; and
an air bridge deploying module, configured to deploy air bridges on the circuit layout along the skeleton lines, and the air bridges on the two skeleton lines in the interweave pair being arranged in a staggered manner.

In a possible implementation, the air bridge deploying module is configured to:
obtain a first endpoint of a first skeleton line in the interweave pair, a vertical line passing through the first endpoint and perpendicular to a second skeleton line intersecting the second skeleton line, and the first skeleton line and the second skeleton line being the two skeleton lines in the interweave pair; and
deploy the air bridges in a staggered manner at a same interval along the first skeleton line and the second skeleton line respectively based on the first endpoint and an intersection between the vertical line and the second skeleton line.

In a possible implementation, the air bridge deploying module is configured to:
take a position of the first endpoint as a deployment position of an air bridge, and deploy the air bridges in sequence at a first interval along the first skeleton line; and
take a position of the intersection as a midpoint between two adjacent air bridges, and deploy the air bridges in sequence at the first interval along the second skeleton line.

In a possible implementation, the air bridge deploying module is configured to:
offset half of a second interval along the first skeleton line starting from the first endpoint, to obtain a first deployment position;
take the first deployment position as a deployment position of an air bridge, and deploy the air bridges in sequence at the second interval along the first skeleton line; and
take a position of the intersection as a deployment position of an air bridge, and deploy the air bridges in sequence at the second interval along the second skeleton line.

In a possible implementation, the interweave pair obtaining module is configured to:
traverse and obtain a skeleton line pair in the skeleton lines of the CPW lines; and
determine the skeleton line pair as the interweave pair in response to a positional relationship between the two skeleton lines in the skeleton line pair satisfying an interweaving condition.

In a possible implementation, the interweaving condition includes at least one of the following conditions:
the two skeleton lines in the skeleton line pair being parallel;
a distance between the two skeleton lines in the skeleton line pair being within a specified distance range; and
an interweaving area existing between the two skeleton lines in the skeleton line pair.

In a possible implementation, the interweave pair obtaining module is configured to traverse and obtain the skeleton line pair formed by straight line segments in the skeleton lines of the CPW lines.

In a possible implementation, the interweave pair obtaining module is configured to:
detect whether the two skeleton lines in the skeleton line pair are parallel;
detect, in response to the two skeleton lines in the skeleton line pair being parallel, whether the distance between the two skeleton lines in the skeleton line pair is within the specified distance range;
detect, in response to the distance between the two skeleton lines in the skeleton line pair being within the specified distance range, whether the interweaving area exists between the two skeleton lines in the skeleton line pair; and
determine, in response to the interweaving area existing between the two skeleton lines in the skeleton line pair, that the positional relationship between the two skeleton lines in the skeleton line pair satisfies the interweaving condition.

In a possible implementation, the interweave pair obtaining module is configured to:
determine four endpoints of the two skeleton lines in the skeleton line pair in sequence;
obtain an opposite end straight line corresponding to each of the four endpoints, the opposite end straight line being a straight line obtained by extending a skeleton line, other than a skeleton line at which the endpoint is located, in the two skeleton lines in the skeleton line pair;
obtain feet of perpendicular from the four endpoints to the respective opposite end straight lines in sequence; and
determine, in response to any of the feet of perpendicular being located within the skeleton lines in the skeleton line pair, that the interweaving area exists between the two skeleton lines in the skeleton line pair.

In a possible implementation, the interweave pair obtaining module is configured to:
obtain respective inclination angles of the two skeleton lines in the skeleton line pair based on the position information of the two skeleton lines in the skeleton line pair; and
determine, in response to the respective inclination angles of the two skeleton lines in the skeleton line pair being the same, and extension lines of the two skeleton lines in the skeleton line pair not intersecting, that the two skeleton lines in the skeleton line pair are parallel.

According to an aspect of embodiments of this application, a computer device is provided, including a memory and a processor, the memory having a computer program stored therein, and the processor being configured to execute the computer program to implement the foregoing method.

According to an aspect of embodiments of this application, a computer-readable storage medium is provided, having a computer program stored therein, the computer program being loaded and executed by a processor to implement the foregoing method.

According to an aspect of embodiments of this application, a computer program product is provided, including a computer program, the computer program being loaded and executed by a processor to implement the foregoing method.

According to an aspect of embodiments of this application, a chip product is provided, including:
CPW lines,
an interweave pair existing in skeleton lines of the CPW lines, and air bridges on the two skeleton lines in the interweave pair being arranged in a staggered manner.

The technical solutions provided in embodiments of this application may bring the following beneficial effects:
For the circuit layout in which the CPW lines are deployed, the position information of the skeleton lines of the CPW lines is determined based on the position information of the CPW lines corresponding to the circuit layout, and then based on the position information of the skeleton lines of the CPW lines, interweave pairs formed by the skeleton lines that have an impact on the air bridge deployment are determined from the skeleton lines. Then, the air bridges are deployed based on the interweave pair, so that in the interweaving area of the interweave pair, the air bridges on the two skeleton lines are arranged in a staggered manner, and a distance between the air bridges on the two skeleton lines of the interweave pair is maximized, thereby reducing impacts between the air bridges on different CPW lines, and improving a success rate of subsequent circuit preparation.

### BRIEF DESCRIPTION OF THE DRAWINGS

FIG. 1 is a schematic diagram of bending, discontinuity, and asymmetry of CPW lines according to an embodiment of this application.
FIG. 2 is a schematic diagram of an air bridge arrangement according to this application.
FIG. 3 is a flowchart of an air bridge deployment method in a circuit layout according to an embodiment of this application.
FIG. 4 is a schematic diagram of a structure of a CPW line according to an embodiment of this application.
FIG. 5 is a schematic diagram of a CPW point set according to an embodiment of this application.
FIG. 6 is a schematic diagram of a CPW point set according to another embodiment of this application.
FIG. 7 is a schematic diagram of a skeleton line of a CPW line according to an embodiment of this application.
FIG. 8 is a schematic diagram of deploying air bridges based on a skeleton line according to an embodiment of this application.
FIG. 9 is a schematic diagram of a structure of a circuit layout having air bridges deployed according to an embodiment of this application.
FIG. 10 is a flowchart of an air bridge deployment method in a circuit layout according to another embodiment of this application.
FIG. 11 is a schematic diagram of an interweave pair according to the embodiment shown in FIG. 10.
FIG. 12 is a schematic diagram of non-interweaved line segments according to the embodiment shown in FIG. 10.
FIG. 13 is a schematic diagram of an interweave pair determining algorithm according to the embodiment shown in FIG. 10.
FIG. 14 is a schematic diagram of an interleave start point according to the embodiment shown in FIG. 10.
FIG. 15 is a schematic diagram of an air bridge layout according to the embodiment shown in FIG. 10.
FIG. 16 is a comparison diagram of an air bridge layout according to the embodiment shown in FIG. 10.
FIG. 17 is a block diagram of an air bridge deployment apparatus in a circuit layout according to an embodiment of this application.
FIG. 18 is a block diagram of a structure of a computer device according to an embodiment of this application.

### DESCRIPTION OF EMBODIMENTS

To make the objectives, technical solutions, and advantages of this application clearer, the following further describes implementations of this application in detail with reference to the accompanying drawings.

Before the embodiments of this application are introduced and described, some terms related to this application are first explained and described.
1. Superconducting quantum chip: It is a central processing unit of a superconducting quantum computer. A quantum computer is a machine that uses the principle of quantum mechanics to calculate. Based on the superposition principle of quantum mechanics and quantum entanglement, the quantum computer has strong parallel processing capabilities and can resolve some problems that are difficult for classical computers to calculate. The zero-resistance characteristics of superconducting qubits and the manufacturing process close to that of an integrated circuit make a quantum computing system constructed using the superconducting qubits become one of the most promising systems for implementing practical quantum computing.
2. Coplanar waveguide (CPW): It is a microwave planar transmission line with superior performance and easy processing, and is used for transmitting microwave signals. Numerous coplanar waveguide technologies are used in superconducting quantum chips.
3. Air bridge: It is a circuit structure that uses a three-dimensional bridge structure to implement planar circuit bridging, which is suitable for various chips, especially for such as flip-chip soldering chips and superconducting quantum chips. Because the medium between the bridge and the circuit is air or vacuum, it is called an air bridge or a vacuum bridge, and is generally referred to as an air bridge.
4. Quantum gate: It is a basic unit in a quantum computing model in a quantum circuit compared with a logic gate in a classical digital circuit, also referred to as a quantum logic gate, and is configured to operate qubits. Unlike a traditional logic gate, the quantum gate is usually represented by using a matrix and is reversible. The quantum gates include Hadamard, Pauli-X, Pauli-Y, Pauli-Z, SWAP, CNOT, and the like.
5. Automatic routing: It is a process of using software to automatically complete layout of circuits in circuit and chip designs, and connecting components according to rules and requirements. The automatic routing is mostly used in large-scale and ultra-large-scale integrated circuit designs, it is one of links, and is usually carried out after the layout is completed.
6. Skeleton line: It is a skeleton line of a center line of a part formed by two parallel curves with the same width and exists in a device in a layout.
7. Interweave pair: It is a line segment pair formed by skeleton lines of two CPW lines in this application, and there is an impact between air bridges deployed along the two skeleton lines. For example, there may be situations in which a distance between the two air bridges belonging to the two skeleton lines is excessively close.
8. Parasitic mode: It is a mode generated in a circuit due to asymmetry, discontinuity and bending of a CPW in a superconducting quantum chip. The parasitic mode may affect line transmission characteristics.
9. Layout: It is also referred to as a circuit layout, is a design drawing that describes how components in a circuit are deployed, placed and connected, and is a planar geometric description of a physical condition of a real circuit. A layout design file includes information such as a shape, an area, and a position of each hardware unit on a chip.

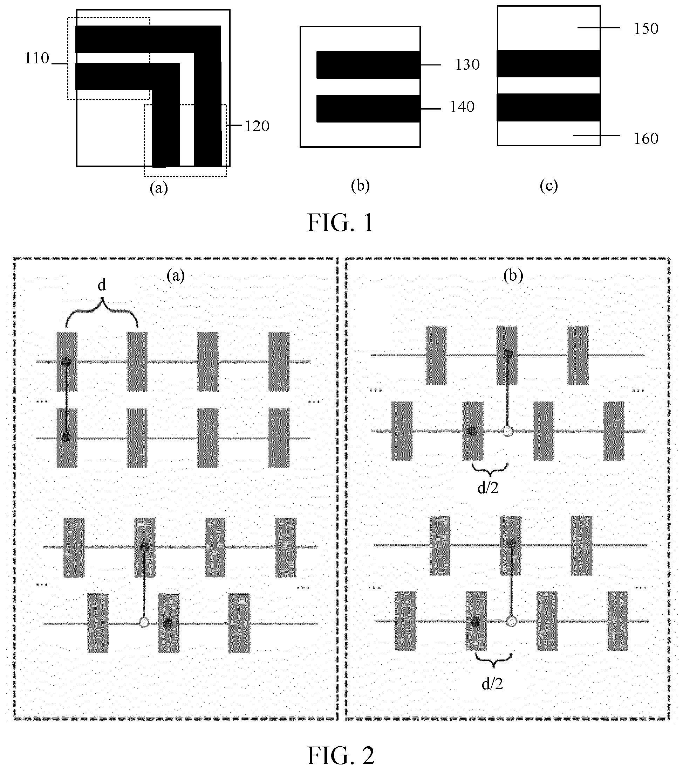

Asymmetry, discontinuity and bending of a CPW line in a superconducting quantum chip causes a parasitic mode in a circuit, affecting line transmission characteristics. FIG. 1 shows a schematic diagram of the foregoing situations. In FIG. 1, two parallel black lines with widths are two CPW groove lines included in CPW lines. Bending of each CPW line means that the CPW line is bent and is not deployed along a straight line. As shown in section (a) in FIG. 1, the CPW line is bent, and a part of a CPW line 110 is perpendicular to a part of a CPW line 120. Discontinuity of each CPW line means that ends of the CPW line are not connected together, but are disconnected. As shown in section (b) in FIG. 1, a part of a CPW line 130 and a part of a CPW line 140 are not connected together. Asymmetry of each CPW line refers to asymmetry of conductor planes on two sides of the CPW line. As shown in section (c) in FIG. 1, a conductor plane 150 and a conductor plane 160 are asymmetric. However, the most commonly used method to suppress the parasitic mode in the CPW line is to deploy air bridges along the CPW line.

There are some layout design tools in the related art that can automatically deploy air bridges along skeleton lines input by a user. A feature of each layout design tool is that the layout design tool relies on coordinate information provided by the user to complete the layout of the air bridges. A specific operation process is as follows: The user inputs one or more skeleton lines, saves the skeleton lines and uses a one-key air bridge generation function to automatically place the air bridges along the skeleton lines.

As a quantity of bits in a quantum processor increases, a quantity of signal lines such as bit reading and control also increases. However, due to a chip size and a layout space limitation, signal lines may be arranged densely in some areas, and special attention needs to be paid to air bridge arrangements in the areas. From the perspective of chip processing, in a case that two signal lines are close and a longitudinal distance between the air bridges is small, the risk of exposure failure may increase due to the optical proximity effect. In addition, after the exposure is completed, photoresist and evaporated metal etching need to be performed on the parts other than the air bridges. Wet etching is usually used. The density of the air bridges affects the local etching temperature and etching solution concentration, thereby affecting an etching rate and a bridge size.

In a process of drawing the air bridges, the air bridges on each line segment are usually evenly distributed according to a spacing d. A positional relationship of the air bridges between two parallel lines can be determined by a position of a foot of perpendicular when starting from a center of one air bridge in one line segment and drawing a vertical line to another parallel line.

FIG. 2 is a schematic diagram of an air bridge arrangement according to this application. If a distance between the foot of perpendicular and a center of each of the left and right air bridges is defined as d/2, it is a completely staggered form, as shown in section (b) in FIG. 2, otherwise, it is a non-completely staggered form, as shown in section (a) in FIG. 2. Adopting the solutions in the related art, if no intervention is performed and air bridges are drawn separately with each line segment as a unit, in most cases, obtained air bridge position distributions are shown in section (a) in FIG. 2 (that is, some places are staggered, and some places are not arranged in a staggered manner, which can also be referred to as non-completely staggered). This causes the distance between the two air bridges to be excessively close, thereby affecting an exposure success rate, an etching speed, and a bridge size during chip processing, and affecting precision of circuit processing.

Based on this, subsequent embodiments of this application provide a solution for an air bridge deployment, which can ensure that in areas at which there may be impacts between air bridge arrangements, air bridges on skeleton lines of two CPW lines can be arranged in a staggered manner, to reduce mutual impacts between the air bridge arrangements on different CPW lines as much as possible.

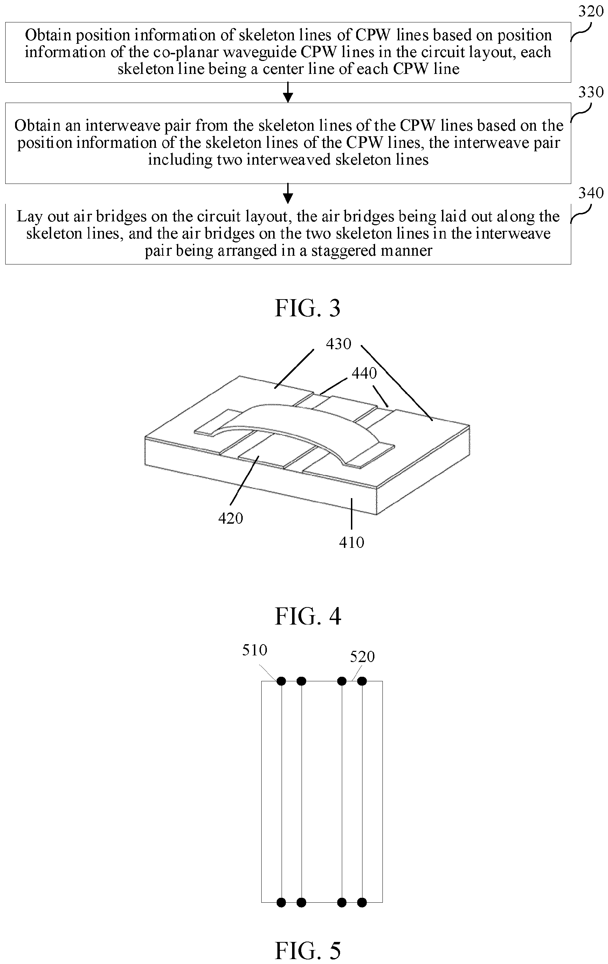

FIG. 3 is a flowchart of an air bridge deployment method in a circuit layout according to an embodiment of this application. The method can be performed by a computer device. The computer device can be any electronic device with computing and storage capabilities, such as a personal computer (PC), tablet computer, server, or the like. For example, the computer device may run a computer program for implementing the method, and the computer program can implement the air bridge deployment method in the circuit layout provided in this embodiment. As shown in FIG. 3, the method may include at least one of the following steps 320 to 340.

Step 320: Obtain position information of skeleton lines of CPW lines based on position information of the coplanar waveguide CPW lines in the circuit layout, each skeleton line being a center line of each CPW line.

In the embodiments of this application including the embodiments of both the claims and the specification (hereinafter referred to as "all embodiments of this application"), the circuit layout is preferably a design diagram that describes how components in the circuit are deployed, placed, and connected, and is preferably a planar geometric description of a physical condition of a real circuit.

In all embodiments of this application, the foregoing circuit layout may be a circuit layout of a quantum chip, such as a circuit layout of a superconducting quantum chip. Numerous coplanar waveguide technologies are used in the superconducting quantum chip.

A layout design file of the circuit layout may include information such as a shape, an area, and a position of each component on the chip. After automatic routing, routing information connecting each point can be added to the layout design file, and finally a layout design file with routing information is generated. The foregoing routing information may include a CPW point set, which is used to define position information of a plurality points of the CPW lines deployed in the circuit layout.

A central conductor strip is made on one surface of a dielectric substrate, and conductor planes are made on two sides adjacent to the central conductor strip, thus forming a CPW line, also referred to as a coplanar microstrip transmission line.

As shown in FIG. 4, a central conductor strip 420 on one surface of a dielectric substrate 410 and conductor planes 430 on two sides of the central conductor strip 420 are CPW lines. In addition, widths of two grooves 440 between the central conductor strip 420 and the conductor planes 430 on two sides are generally the same. According to a processing flow, the two grooves 440 are usually drawn in an actual layout to represent the CPW lines.

The CPW point set includes position information of n points used to define CPW lines deployed in the circuit layout. A quantity of points used to describe CPW is determined by used software. For example, a common file format for the superconducting quantum chip layout is Graphic Design System II (GDSII). In the software, a straight line segment (with a width) is usually described by coordinates of four endpoints, and an arc part is described by a series of equidistant points.

In all embodiments of this application, the position information of the n points of the CPW lines can be expressed in the form of coordinates. For example, a two-dimensional coordinate system is established with a center of the circuit layout as an origin, and the position information of the n points of the CPW lines is expressed in the form of two-dimensional coordinates (x, y).

In all embodiments of this application, points in the CPW point set can be located at edges of CPW groove lines with widths. Each edge of each CPW groove line refers to the boundary of the CPW groove line with a width. For example, as shown in FIG. 5, CPW lines include two parallel CPW groove lines 520. Small black dots in the figure are points 510 in a CPW point set located on two edges of each CPW groove line 520 with a width.

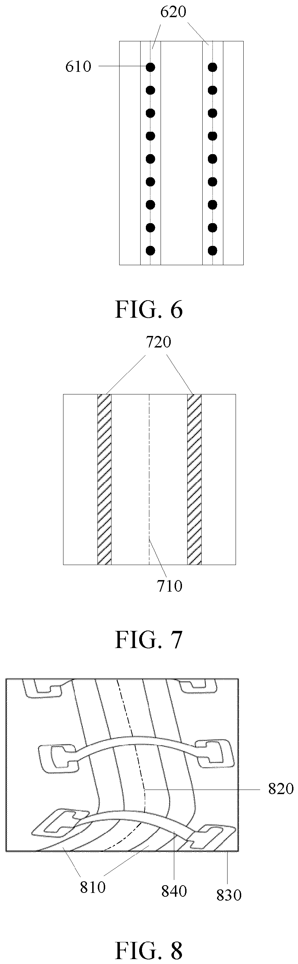

In all embodiments of this application, alternatively, the points in the CPW point set can be located at a center line of the CPW groove line with the width. The center line of the CPW groove line refers to a line used to identify a center of the CPW groove line with the width. A distance from any point on two edges of the CPW groove line to the center line of the CPW groove line is the same. For example, as shown in FIG. 6, CPW lines include two parallel CPW groove lines 620. Small black dots in the figure are points 610 in a CPW point set located on a center line of each CPW groove line 620 with a width. Optionally, the center line is parallel to the CPW groove line.

In all embodiments of this application, position information of skeleton lines of CPW lines can be determined based on position information of points in the CPW point set corresponding to the CPW lines. Optionally, a first center line corresponding to a first CPW groove line is determined based on position information of points on the first CPW groove line. Optionally, a second center line corresponding to a second CPW groove line is determined based on position information of points on the second CPW groove line. Optionally, the first CPW groove line and the second CPW groove line form a CPW line. Optionally, a center line between the first center line and the second center line is determined as a skeleton line of the CPW line. In some embodiments, points in the CPW point set obtained by a computer device include points on the first center line on the first CPW groove line, and points on the second center line on the second CPW groove line. Optionally, two parallel straight lines are determined according to distribution of the points in the CPW point set, the two parallel straight lines are used as the first center line and the second center line, and the center line between the first center line and the second center line are determined as the skeleton line of the CPW line.

In all embodiments of this application, the computer device can determine the positions of the two parallel CPW groove lines included in the CPW lines based on the position information of the n points in the CPW point set, and can further determine the skeleton line of the CPW line.

A center line of the two parallel CPW groove lines refers to a line used to identify centers of the two parallel CPW groove lines. A distance from any point on each center line of each CPW groove line to the center line of the two parallel CPW groove lines is the same. For example, as shown in FIG. 7, a skeleton line 710 of CPW lines refers to a center line of two parallel CPW groove lines 720 included in the CPW lines.

Step 330: Obtain an interweave pair from the skeleton lines of the CPW lines based on the position information of the skeleton lines of the CPW lines, the interweave pair including two interweaved skeleton lines.

In all embodiments of this application, the computer device can detect, based on the position information of the skeleton lines of the CPW lines, whether there is an interweave pair in the skeleton lines of the CPW lines. The interweave pair refers to two skeleton lines with an interweaving area. Air bridges deployed along the two skeleton lines in the middle of the foregoing interweave pair may affect each other in the interweaving area, for example, a distance between air bridges on one skeleton line and air bridges on the other skeleton line may be excessively close.

In all embodiments of this application, the interweave pair preferably includes two skeleton lines with the interweaving area. Optionally, the interweaving area is an area at which the deployment of the air bridges on the two skeleton lines in the interweave pair affects each other. Optionally, the interweaving area means that the two skeleton lines overlap in a vertical direction. Optionally, vertical lines are drawn at two endpoints of one of the two skeleton lines respectively, and whether the two vertical lines intersect with another skeleton line is determined. If there is at least one intersection, it is considered that the two skeleton lines have an interweaving area.

Step 340: Deploy air bridges on the circuit layout, the air bridges being deployed along the skeleton lines, and the air bridges on the two skeleton lines in the interweave pair being arranged in a staggered manner.

In all embodiments of this application, the air bridges are preferably deployed along the skeleton lines, and the air bridges on the two skeleton lines in the interweave pair are arranged in a staggered manner in the interweaving area. Optionally, air bridges are deployed at a preset distance on all skeleton lines on the circuit layout. Optionally, a plurality of air bridges are deployed on one skeleton line.

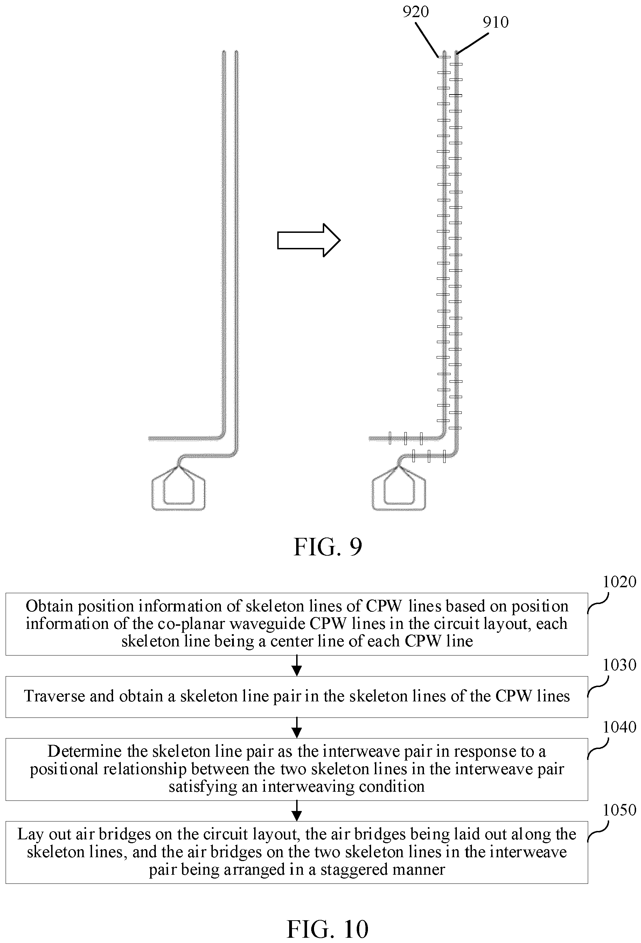

In all embodiments of this application, alternatively, the skeleton line of the CPW line is used as a center line, and an air bridge connecting conductor planes on two sides of the CPW line is deployed on the CPW line. For example, as shown in FIG. 8, air bridges 840 are deployed on a circuit layout 830 according to a skeleton line 820 of CPW lines 810. A circuit layout completed with an air bridge deployment is shown in FIG. 9, in which 910 is a CPW line and 920 is an air bridge.

In all embodiments of this application, air bridges can be deployed on the circuit layout at an equal distance along skeleton lines of CPW lines. For example, a skeleton line of a CPW line is used as a center line, and air bridges are deployed on the CPW line at an equal interval. For example, taking the skeleton line of the CPW line as the center line, air bridges are deployed on the CPW line every 20 microns.

In all embodiments of this application, in a case that the air bridges are deployed on a circuit layout based on the interweave pair, for the air bridges in the interweaving area, the computer device can deploy the air bridges on the two skeleton lines in the interweave pair in a staggered manner, which can also be referred to as completely staggered. The foregoing staggered manner can also refer to a foot of perpendicular of an extension line of air bridges on one skeleton line in the interweave pair on the other skeleton line, and a distance from any air bridge on the other skeleton line is greater than a distance threshold.

To sum up, according to technical solutions provided in the embodiments of this application, for the circuit layout in which the CPW lines are deployed, the position information of the skeleton lines of the CPW lines is determined based on the position information of the CPW lines corresponding to the circuit layout, and then based on the position information of the skeleton lines of the CPW lines, interweave pairs formed by the skeleton lines that have an impact on the air bridge deployment are determined from the skeleton lines. Then, the air bridges are deployed based on the interweave pair, so that in the interweaving area of the interweave pair, the air bridges on the two skeleton lines are arranged in a staggered manner, and a distance between the air bridges on the two skeleton lines of the interweave pair is maximized, thereby reducing impacts between the air bridges on different CPW lines, and improving a success rate of subsequent circuit preparation.

FIG. 10 is a flowchart of an air bridge deployment method in a circuit layout according to another embodiment of this application. The method may be performed by a computer device. The method may include the following steps:
Step 1020: Obtain position information of skeleton lines of CPW lines based on position information of the coplanar waveguide CPW lines in the circuit layout, each skeleton line being a center line of each CPW line.

For a specific implementation process of step 1020, refer to the description of step 320, and details are not described herein again.

Step 1030: Traverse and obtain a skeleton line pair in the skeleton lines of the CPW lines.

In all embodiments of this application, the computer device can traverse and obtain two skeleton lines in the skeleton lines of the CPW lines as a skeleton line pair.

In all embodiments of this application, the traversing and obtaining a skeleton line pair in the skeleton lines of the CPW lines includes: traversing and obtaining the skeleton line pair formed by straight line segments in the skeleton lines of the CPW lines.

In this embodiment of this application, in a case that two CPW lines are parallel straight lines and close to each other, air bridges of the two CPW lines may affect each other. Based on this, in this embodiment of this application, the computer device can traverse and find interweave pairs for the straight CPW lines. Therefore, in a case that the computer device traverses and obtains the skeleton line pairs in the skeleton lines of the CPW lines, the computer device can traverse and obtain the skeleton line pairs formed by the straight line segments. Of course, in the skeleton lines of the CPW line, in a case that skeleton line pair formed by arc segments are close to each other, air bridges of the two CPW lines may also affect each other. Based on this, in this embodiment of this application, the computer device can traverse and find interweave pairs for arc-shaped CPW lines. The following only explains an air bridge deployment of the skeleton line pair formed by the straight line segments. For an air bridge deployment of the skeleton line pair formed by the arc segments, refer to the air bridge deployment of the skeleton line pair formed by the straight line segments. This is not described in detail.

There may be numerous straight CPW lines in a circuit layout of a chip. If skeleton lines of every two straight CPW lines are formed into a skeleton line pair, an amount of calculation is excessively large and calculation efficiency is affected. Based on this, in this embodiment of this application, the computer device can first divide the circuit layout into at least two blocks, and then traverse skeleton line pairs formed by straight line segments in the CPW lines of blocks.

Step 1040: Determine the skeleton line pair as the interweave pair in response to a positional relationship between the two skeleton lines in the skeleton line pair satisfying an interweaving condition.

The interweave pair includes two skeleton lines with an interweaving area. The interweaving area is an area at which the air bridge deployment on the two skeleton lines in the interweave pair affects each other.

In all embodiments of this application, the interweaving condition preferably includes at least one of the following:
the two skeleton lines in the skeleton line pair being parallel;
a distance between the two skeleton lines in the skeleton line pair being within a specified distance range; and
an interweaving area existing between the two skeleton lines in the skeleton line pair.

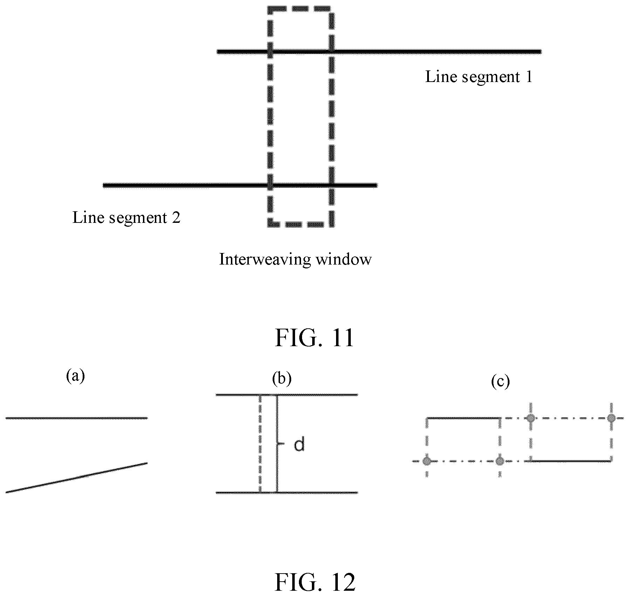

In all embodiments of this application, the definition of an interweave pair is preferably first given: Two line segments in which a distance between parallel lines is less than a certain threshold and there are two line segments with an "interweaving area" along a direction of the line segments, as shown in FIG 11, a schematic diagram of an interweave pair according to an embodiment of this application is shown.

In all embodiments of this application, the definition of the interweave pair preferably has three criteria:
1. Straight lines at which line segments are located are parallel.
2. A parallel line distance d is less than or equal to a preset maximum interweaving distance dmax, and is greater than or equal to a preset value dmin.
3. An "interweaving window" exists.

The third criterion, the existence of the "interweaving window" can be specifically expressed as: There is an endpoint of one line segment, a vertical line is drawn to a straight line determined by another line segment, and a foot of perpendicular is located inside a line segment of the another line segment.

To better explain the definition of a parallel interweave pair, FIG. 12 shows a schematic diagram of non-interweaved line segments according to an embodiment of this application. As shown in section (a) in FIG. 12, if two line segments are not parallel, the two line segments are not "interweaved". As shown in section (b) in FIG. 12, if a distance between two parallel line segments is excessively large, the two line segments are also not "interweaved". As shown in section (c) in FIG. 12, the two line segments satisfy the first and second criteria in the definition, but the two line segments are completely staggered and there is no "interweaving window", therefore, the two line segments cannot form an interweave pair.

According to the technical solutions provided in the embodiments of this application, in a case that the interweave pair is obtained from the skeleton lines of the CPW lines, skeleton line pairs in the skeleton lines of the CPW lines are first traversed, and skeleton line pairs of which positional relationships satisfy the interweaving conditions are determined. Because the skeleton line pairs in the CPW lines are traversed to further determine the interweave pair, the determined interweave pairs are sufficient, that is, all skeleton lines with interweaving areas are defined. This is beneficial to use the air bridge deployment method provided in the embodiments of this application to subsequently deploy the air bridges for the CPW lines with the interweaving areas, so that an air bridge deployment is good.

In addition, based on the fact that the two skeleton lines in the skeleton line pair are parallel, the distance between the two skeleton lines in the skeleton line pair is within a specified distance range, and the interweaving area exists between the two skeleton lines in the skeleton line pair, the interweave pair is determined, so that the determining of the interweave pair is accurate, thereby facilitating the progress of downstream tasks.

In all embodiments of this application, before the determining the skeleton line pair as the interweave pair in response to a positional relationship between the two skeleton lines in the skeleton line pair satisfying an interweaving condition, the method may further include:
detecting whether the two skeleton lines in the skeleton line pair are parallel;
detecting, in response to the two skeleton lines in the skeleton line pair being parallel, whether the distance between the two skeleton lines in the skeleton line pair is within the specified distance range, and optionally, determining that the two skeleton lines do not satisfy the interweaving condition if it is detected that the two skeleton lines in the skeleton line pair are not parallel; and
detecting, in response to the distance between the two skeleton lines in the skeleton line pair being within the specified distance range, whether the interweaving area exists between the two skeleton lines in the skeleton line pair, and optionally, determining that the two skeleton lines do not satisfy the interweaving condition if it is detected that a distance between the two skeleton lines in the skeleton line pair being not within the specified distance range; and
determining, in response to the interweaving area existing between the two skeleton lines in the skeleton line pair, that the positional relationship between the two skeleton lines in the skeleton line pair satisfies the interweaving condition, and optionally, determining that the two skeleton lines do not satisfy the interweaving condition if it is detected that the interweaving area does not exist between the two skeleton lines in the skeleton line pair.

In all embodiments of this application, the computer device can detect whether the two skeleton lines satisfy the interweaving condition in the order of whether the two skeleton lines are parallel-whether the distance is within the specified distance range-whether there is an interweaving area. In this process, provided that one condition is detected to be unsatisfied, then it is determined that the two skeleton lines do not satisfy the interweaving conditions, and the detection is stopped.

According to the technical solutions provided in embodiments of this application, it is easy to determine whether the skeleton line pair formed by straight segments in the skeleton lines of the CPW lines satisfy the interweaving conditions. Because straight lines intersect if the straight lines are not parallel, in a case that the straight lines at which the straight line segments are located intersect, it is considered that the skeleton line pair formed by the straight line segments may have no non-interweaving area, in a case that the straight lines at which the straight line segments are located are parallel, it is considered that the skeleton line pair formed by the straight line segments may have a non-interweaving area. Therefore, it is beneficial to improve efficiency of determining an interweave pair. In all embodiments of this application, the detecting whether the interweaving area exists between the two skeleton lines in the skeleton line pair may include:
determining four endpoints of the two skeleton lines in the skeleton line pair in sequence;
obtaining opposite end straight lines respectively corresponding to the four endpoints, each opposite end straight line being a straight line obtained by extending to two sides a skeleton line in the two skeleton lines in the skeleton line pair other than a skeleton line at which the endpoint is located;
obtaining feet of perpendicular from the four endpoints to the respective opposite end straight lines in sequence; and
determining, in response to any of the feet of perpendicular being located within the skeleton lines in the skeleton line pair, the interweaving area exists between two skeleton lines in skeleton line pair.

In all embodiments of this application, alternatively, it is determined, in response to any of the feet of perpendicular being not located within the skeleton lines in the skeleton line pair, but a distance between the foot of perpendicular and the closest endpoint in the four endpoints being less than a distance threshold, that the interweaving area exists between the two skeleton lines in the skeleton line pair. In other words, although the skeleton line pair does not overlap in a vertical direction, because a horizontal distance between the two skeleton lines is close, it is considered that an interweaving area exists between the two skeleton lines in the skeleton line pair. In a case that the horizontal distance between the two is close, it is considered that the interweaving area exists between the two skeleton lines in the skeleton line pair. In this case, a deployment of an air bridge can be considered non-completely perpendicular to the interweave pair, but to deploy the air bridge at an acute or obtuse angle with the interweave pair, so that two ends of the air bridge are still at two sides of the interweave pair.

In the embodiment of this application, for the two skeleton lines in the skeleton line pair, the computer device can determine the endpoints of the two skeleton lines in sequence (a total of 4 endpoints), and then determine the opposite end straight lines corresponding to the 4 endpoints respectively. Each opposite end straight line is a straight line at which another skeleton line is located outside the skeleton line at which a current endpoint is located. For two endpoints of the same skeleton line, the corresponding opposite end straight lines are the same. Then, the computer device calculates feet of perpendicular lines from each of the four endpoints to the corresponding opposite end straight lines. If the calculated feet of the perpendicular lines are on another skeleton line, it is considered that the interweaving area exists between the two skeleton lines in the skeleton line pair. Otherwise, continue to calculate a foot of perpendicular corresponding to the next endpoint until it is determined that there is an interweaving area between the two skeleton lines in the skeleton line pair. If the feet of perpendicular corresponding to all the endpoints have been calculated and no foot of perpendicular on another skeleton line are found, it is considered that an interweaving area exists between the two skeleton lines in the current skeleton line pair. In this embodiment of this application, when whether an interweaving area exists between two skeleton lines is determined, a vertical line is drawn to determine whether there is an overlapping part between the two skeleton lines in the vertical direction, thereby determining whether an interweaving area exists. Therefore, the determining of interweaving areas is proper in this embodiment of this application. Further, when whether an interweaving area exists between the two skeleton lines in the skeleton line pair, it is not only based on whether the foot of perpendicular is on the line segment, but also based on a situation that the foot of perpendicular is outside the line segment, giving a possibility of an interweaving area. In this case, decision robustness of the interweaving area is better.

In all embodiments of this application, the detecting whether the two skeleton lines in the skeleton line pair are parallel may include:
obtaining respective inclination angles of the two skeleton lines in the skeleton line pair based on the position information of the two skeleton lines in the skeleton line pair.

In all embodiments of this application, the position information of the skeleton lines in the skeleton line pair may include the inclination angle information of the skeleton line. Optionally, the position information includes an inclination angle 1 of a skeleton line 1 and an inclination angle 2 of a skeleton line 2. The skeleton line 1 and the skeleton line 2 are the two skeleton lines in the skeleton line pair. Alternatively, in a case that the skeleton line is a straight line segment, the position information includes at least coordinate information of point 1, point 2, point 3, and point 4. The point 1 and point 2 are located on the skeleton line 1, and the point 3 and point 4 are located on the skeleton line 2. Optionally, according to the coordinate information corresponding to the point 1 and point 2, the inclination angle of the skeleton line 1 is determined, and according to the coordinate information corresponding to the point 3 and point 4, the inclination angle of the skeleton line 2 is determined. Optionally, the coordinate of the point 1 is (a1, b 1), the coordinate information of the point 2 is (a2, b2), then the inclination angle of the skeleton line 1 is (b2-b1)/(a2-a1). Optionally, the coordinate of the point 3 are (a3, b3), the coordinate information of the point 4 is (a4, b4), then the inclination angle of the skeleton line 2 is (b4-b3)/(a4-a3). a1 is not equal to a2, and a3 is not equal to a4.

It is determined, in response to the respective inclination angles of the two skeleton lines in the skeleton line pair being the same, and extension lines of the two skeleton lines in the skeleton line pair not intersecting, that the two skeleton lines in the skeleton line pair are parallel.

In all embodiments of this application, if the inclination angle 1 is equal to the inclination angle 2, and the extension lines of the two skeleton lines in the skeleton line pair do not intersect, it is determined that the two skeleton lines in the skeleton line pair are parallel. In all embodiments of this application, if the inclination angle 1 is not equal to the inclination angle 2, it is determined that the two skeleton lines in the skeleton line pair are parallel.

In this embodiment of this application, because the skeleton line in the traversed skeleton line pair is a straight line, the computer device can calculate the inclination angle of the skeleton line based on the coordinates of any two points on the skeleton line. If the inclination angles of the two skeleton lines in one skeleton line pair are the same, the two skeleton lines in the current skeleton line pair are considered to be parallel, otherwise, the two skeleton lines in the current skeleton line pair are considered to be non-parallel. In this embodiment of this application, when whether the skeleton line pair is parallel is determined, the determining of whether the skeleton line pair is parallel is more accurate by extending the line segments and determining whether angles between the straight lines are the same, thereby improving accuracy of determining the interweave pair.

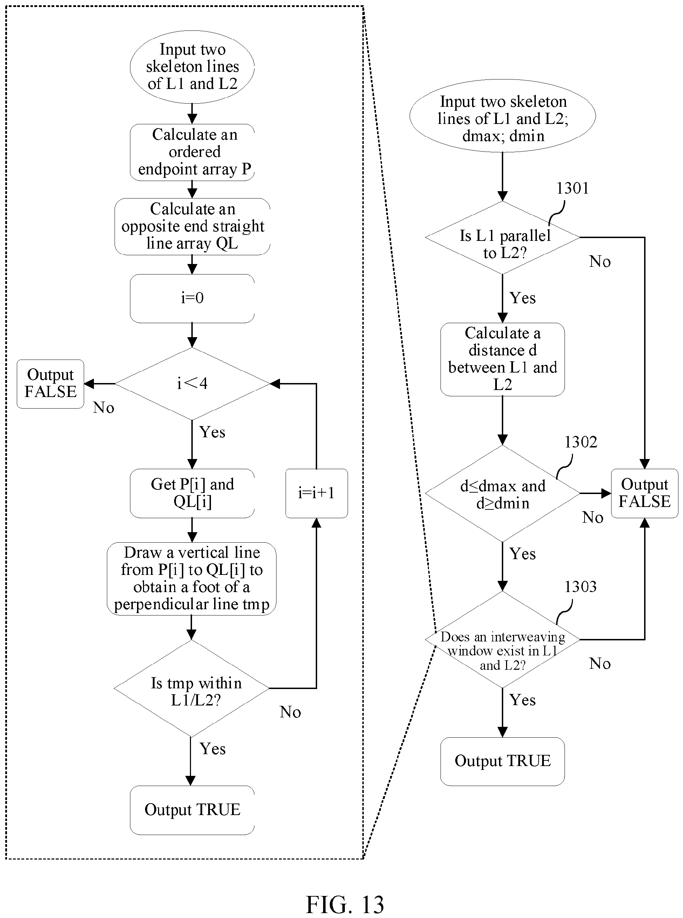

FIG. 13 is a schematic diagram of an interweave pair determining algorithm according to an embodiment of this application. Based on the foregoing criteria, this application adopts the interweave pair determining algorithm as shown in FIG. 13, to determine based on the three criteria of frame lines 1301, 1302 and 1303 in the figure respectively. Once a certain criterion is not satisfied, it is returned that the two line segments are not an interweave pair. Only in a case that all three criteria are satisfied, the two line segments are output as an interweave pair. A detailed determining process of the third criterion "interweaving window" (that is, interweaving area) is given in an enlarged picture on the left side of FIG. 13: The algorithm tries four endpoints of two straight lines in sequence. If a situation consistent with the foregoing expression is found, it is considered that an interweaving window exists. The specific steps may be as follows:
(1) Input two skeleton lines: L1 and L2.
(2) Calculate an ordered endpoint array P, which is the four endpoints on L1 and L2. P={L1.p1, L1.p2, L2.p1, L2.p2}.
   L1.p1 is endpoint 1 of L1, L1.p2 is endpoint 2 of L1, L2.p1 is endpoint 1 of L2, and L2.p2 is endpoint 2 of L2.
(3) Calculate an opposite end straight line array of the ordered endpoint array P: QL={l2, l2, l1, l1}.
   11 is a straight line at which L1 is located, and l2 is a straight line at which L2 is located. l2 corresponds to L1.p1 and L1.p2, and 11 corresponds to L2.p1 and L2.p2.
(4) Assume i is an element serial number in the currently selected P and QL, and initialize i=0.
   It is assumed that serial numbers of the four endpoints in P are 0, 1, 2, and 3 respectively. Correspondingly, it is assumed that the serial numbers of the four straight lines in QL are 0, 1, 2, and 3 respectively.
(5) Determine whether i is less than 4, if so, perform step (6), otherwise, output a result of false, indicating that no "interweaving window" exists for the two input skeleton lines.
(6) Take the current endpoint as P[i] and the current opposite end straight line as QL[i].
   For example, taking i=0 as an example, P[i] is L1.p1, and QL[i] is l2, and so on.
(7) Draw a vertical line from P[i] to QL[i] to obtain a foot of perpendicular tmp.
(8) Determine whether tmp is within a skeleton line corresponding to the corresponding skeleton line QL[i]. If so, output a result of true, indicating that no "interweaving window" exists for the two input skeleton lines. Otherwise, add 1 to the value of i and return to step (5).

For example, taking i=0 as an example, the skeleton line corresponding to QL[i] is L2, then whether tmp is within L2 is determined. If so, determine that the two input skeleton lines form an interweave pair, otherwise, return to step (5).

Step 1050: Deploy air bridges on the circuit layout, the air bridges being deployed along the skeleton lines, and the air bridges on the two skeleton lines in the interweave pair being arranged in a staggered manner.

In all embodiments of this application, a process of deploying air bridges on the circuit layout based on the interweave pair may include:

S1050a: Obtain a first endpoint of a first skeleton line in the interweave pair, a vertical line passing through the first endpoint and perpendicular to a second skeleton line intersecting the second skeleton line, and the first skeleton line and the second skeleton line being the two skeleton lines in the interweave pair.

S1050b: Deploy the air bridges in a staggered manner at a same interval along the first skeleton line and the second skeleton line respectively based on the first endpoint and an intersection between the vertical line and the second skeleton line.

According to the technical solutions provided in the embodiments of this application, in a case that air bridges are deployed on the circuit layout, the air bridges are further deployed according to the endpoints of the interweave pair and the intersection point that passes through the endpoints and intersect with the opposite end straight lines, so that the deployment of the air bridges not only takes into account the interweave pair, different deployments are determined according to different interweaving situations, making the deployment of the air bridges more flexible and more consistent with the actual situation. This is conducive to improving an effect of an air bridge deployment.

In all embodiments of this application, the deploying the air bridges in a staggered manner at a same interval along the first skeleton line and the second skeleton line respectively based on the first endpoint and an intersection between the vertical line and the second skeleton line may include:
taking a position of the first endpoint as a deployment position of an air bridge, and deploy the air bridges in sequence at a first interval along the first skeleton line; and
taking a position of the intersection as a midpoint between two adjacent air bridges, and deploy the air bridges in sequence at the first interval along the second skeleton line.

In all embodiments of this application, the deploying the air bridges in a staggered manner at a same interval along the first skeleton line and the second skeleton line respectively based on the first endpoint and an intersection between the vertical line and the second skeleton line may include:
offsetting half of a second interval along the first skeleton line starting from the first endpoint, to obtain a first deployment position;
taking the first deployment position as a deployment position of an air bridge, and deploying the air bridges in sequence at the second interval along the first skeleton line; and
taking a position of the intersection as a deployment position of an air bridge, and deploying the air bridges in sequence at the second interval along the second skeleton line.

After it is determined that the two line segments are the interweave pair, the next step is to ensure that the air bridges on the interweave pair are completely staggered. It is mainly divided into two stages. The first stage is to mark attributes for the interweave pair, and the second stage is to deploy the air bridges for straight lines based on the marked attributes.

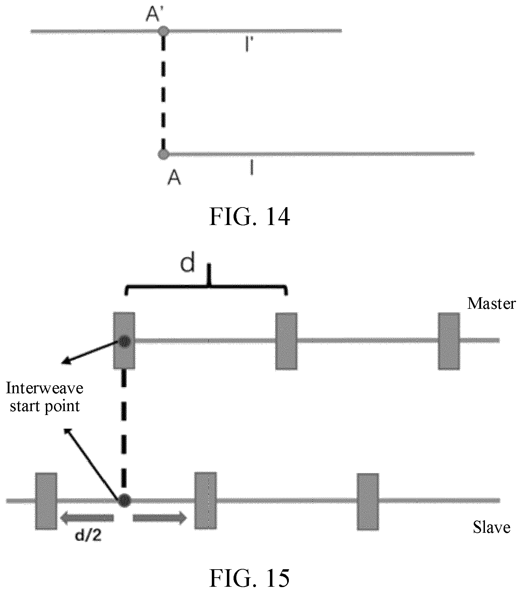

In an attribute marking stage, two concepts are defined in this solution. First, the concept of an interweave start point is introduced for each line segment. Then, an algorithm determines a "master-slave relationship" of the line segment pair. Because it is known that the two line segments are the interweave pair, there is an endpoint A of one line segment 1, which is perpendicular to another line segment l', and a perpendicular center A' is located within the line segment l'. A is referred to as the interweave start point of the line segment l, and A' is the interweave start point of l'. FIG. 14 is a schematic diagram of an interleave start point according to an embodiment of this application.

Because a choice of the interweave start point is not unique, in this case, this solution can select a pair of interweave start points. Then, one of the straight lines is marked as a master line, and another straight line is marked as a slave line. Until now, the first stage of marking is completed.

After attributes are marked on the interweave pair, air bridges can be drawn according to the master-slave relationship, FIG. 15 shows a schematic diagram of an air bridge deployment according to an embodiment of this application.

As shown in FIG. 15, for the master line, the drawing of the air bridges starts from the interweave start point, and the air bridges are arranged at a distance of d along the left and right directions until two ends of the straight line. For the slave line, it is necessary to ensure that air bridge distribution of the slave line is completely staggered with the master line. Therefore, in this solution, a length of d/2 in two directions is staggered along the interweave start point of the slave line for drawing air bridges of the slave line, and the air bridges are drawn according to the distance of d until it reaches two ends of the line segment.

The technical solutions provided in the embodiments of this application adopts different air bridge deployment methods for different master-slave line segment relationships, therefore, it is conducive to satisfying different user needs and improving flexibility of an air bridge deployment. However, even the different air bridge deployment methods are all based on the consideration of maximizing the distance between the air bridges on the two skeleton lines of the interweave pair. An equidistant deployment of air bridges is to maximize a deployment effect and avoid failure in the preparation of a circuit chip due to uneven deployment positions.

In all embodiments of this application, during a process of deploying air bridges on the circuit layout based on the interweave pair, if an air bridge is deployed on a fifth skeleton line in the interweave pair, then the computer device can use a position of the fifth skeleton line corresponding to an air bridge that has been deployed in an interweaving area as a reference position. From this reference position, a vertical line is drawn to a sixth skeleton line in the interweave pair to obtain a foot of perpendicular of the vertical line in the sixth skeleton line. Starting from the foot of perpendicular of the vertical line in the sixth skeleton line and offsetting along the sixth skeleton line by half of a third interval to obtain a second deployment position. The second deployment position is taken as a deployment position of an air bridge, and the air bridges are deployed in sequence at the third interval along the sixth skeleton line. The foregoing third interval is the same as an interval between the air bridges deployed in the fifth skeleton line.

In this embodiment of this application, there may be an interweaving area between one skeleton line 1 and two other skeleton lines (skeleton line 2 and skeleton line 3) in the circuit layout. In this case, skeleton line 1 can form an interweave pair with the skeleton line 2 and the skeleton line 3 respectively. According to the foregoing solution, the computer device can first deploy the air bridges in a staggered manner along the skeleton line 1 and the skeleton line 2 according to the interweave pair formed by the skeleton line 1 and the skeleton line 2. Then, in a case that the air bridges are laid out based on the interweave pair formed by the skeleton line 1 and the skeleton line 3, because the computer device has deployed the air bridges along the skeleton line 1, in this case, the computer device can deploy the air bridges along the skeleton line 3 in a manner that completely staggers with the air bridges in the skeleton line 1.

The following introduces key nodes in a code implementation process of the foregoing air bridge interweaving algorithm.

First, the solutions shown in the embodiments of this application allow a user to define a maximum distance of the interweave pair (dmax in the above) through an interweave_parallel_gap field in the input of the algorithm. If the user does not perform settings, a default value can be set to 0, that is, all straight skeleton lines in the layout cannot form interweave pairs. In addition, the user is allowed to specify the dmin above by setting an interweave_parallel_exclusion field. Specific codes are as follows:
Interweave_parallel_gap: 150
Interweave_parallel_exclusion: 20

The foregoing two lines of code indicate setting the foregoing dmax to 150 and dmin to 20.

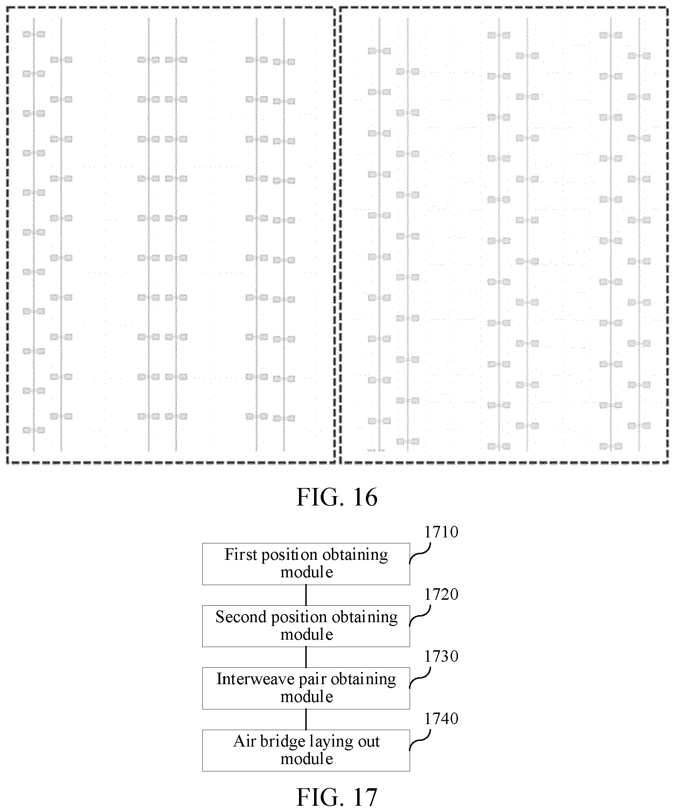

FIG. 16 is a comparison diagram of an air bridge deployment according to an embodiment of this application. It can be learned from the left part in FIG. 16 that before using an interweaving scheme of this application, a relative position of the air bridges on the interweave pair is random. It can be learned from the right part in FIG. 16 that after using the interweaving scheme of this application, the air bridges on the interweave pair are all in a completely staggered state.

To sum up, according to technical solutions provided in the embodiments of this application, for the circuit layout in which the CPW lines are deployed, the position information of the skeleton lines of the CPW lines is determined based on the position information of the CPW lines corresponding to the circuit layout, and then based on the position information of the skeleton lines of the CPW lines, interweave pairs formed by the skeleton lines that have an impact on the air bridge deployment are determined from the skeleton lines. Then, the air bridges are deployed based on the interweave pair, so that in the interweaving area of the interweave pair, the air bridges on the two skeleton lines are arranged in a staggered manner, and a distance between the air bridges on the two skeleton lines of the interweave pair is maximized, thereby reducing impacts between the air bridges on different CPW lines, and improving a success rate of subsequent circuit preparation.

Apparatus embodiments of this application are described below, and may be used to implement the method embodiments of this application. For details not disclosed in the apparatus embodiments of this application, refer to the method embodiments of this application.

FIG. 17 is a block diagram of an air bridge deployment apparatus in a circuit layout according to an embodiment of this application. The apparatus has a function of implementing the foregoing method examples, and the function may be implemented by using hardware, or may be implemented by using hardware executing corresponding software. The device may be the computer device introduced above, or may be provided in the computer device. As shown in FIG. 17, the apparatus 1700 includes:

a second position obtaining module 1720, configured to obtain position information of skeleton lines of CPW lines based on position information of the coplanar waveguide CPW lines in the circuit layout, each skeleton line being a center line of each CPW line;

an interweave pair obtaining module 1730, configured to obtain an interweave pair from the skeleton lines of the CPW lines based on the position information of the skeleton lines of the CPW lines, the interweave pair including two interweaved skeleton lines; and

an air bridge deploying module 1740, configured to deploy air bridges on the circuit layout, the air bridges being deployed along the skeleton lines, and the air bridges on the two skeleton lines in the interweave pair being arranged in a staggered manner.

In a possible implementation, the first position obtaining module 1710 is configured to obtain the position information of the coplanar waveguide CPW lines in the circuit layout.

In a possible implementation, the air bridge deploying module 1740 is configured to:
obtain a first endpoint of a first skeleton line in the interweave pair, a vertical line passing through the first endpoint and perpendicular to a second skeleton line intersecting the second skeleton line, and the first skeleton line and the second skeleton line being the two skeleton lines in the interweave pair; and
deploy the air bridges in a staggered manner at a same interval along the first skeleton line and the second skeleton line respectively based on the first endpoint and an intersection between the vertical line and the second skeleton line.

In a possible implementation, the air bridge deploying module 1740 is configured to:
take a position of the first endpoint as a deployment position of an air bridge, and deploy the air bridges in sequence at a first interval along the first skeleton line; and
take a position of the intersection as a midpoint between two adjacent air bridges, and deploy the air bridges in sequence at the first interval along the second skeleton line.

In a possible implementation, the air bridge deploying module 1740 is configured to:
offset half of a second interval along the first skeleton line starting from the first endpoint, to obtain a first deployment position;
take the first deployment position as a deployment position of an air bridge, and deploy the air bridges in sequence at the second interval along the first skeleton line; and
take a position of the intersection as a deployment position of an air bridge, and deploy the air bridges in sequence at the second interval along the second skeleton line.

In a possible implementation, the interweave pair obtaining module 1730 is configured to:
traverse and obtain a skeleton line pair in the skeleton lines of the CPW lines; and
determine the skeleton line pair as the interweave pair in response to a positional relationship between the two skeleton lines in the skeleton line pair satisfying an interweaving condition.

In a possible implementation, the interweaving condition includes at least one of the following conditions:
the two skeleton lines in the skeleton line pair being parallel;
a distance between the two skeleton lines in the skeleton line pair being within a specified distance range; and
an interweaving area existing between the two skeleton lines in the skeleton line pair.

In a possible implementation, the interweave pair obtaining module 1730 is configured to traverse and obtain the skeleton line pair formed by straight line segments in the skeleton lines of the CPW lines.

In a possible implementation, the interweave pair obtaining module 1730 is configured to:
detect whether the two skeleton lines in the skeleton line pair are parallel;
detect, in response to the two skeleton lines in the skeleton line pair being parallel, whether the distance between the two skeleton lines in the skeleton line pair is within the specified distance range;
detect, in response to the distance between the two skeleton lines in the skeleton line pair being within the specified distance range, whether the interweaving area exists between the two skeleton lines in the skeleton line pair; and
determine, in response to the interweaving area existing between the two skeleton lines in the skeleton line pair, that the positional relationship between the two skeleton lines in the skeleton line pair satisfies the interweaving condition.

In a possible implementation, the interweave pair obtaining module 1730 is configured to:
determine four endpoints of the two skeleton lines in the skeleton line pair in sequence;
obtain opposite end straight lines respectively corresponding to the four endpoints, each opposite end straight line being a straight line obtained by extending to two sides a skeleton line in the two skeleton lines in the skeleton line pair other than a skeleton line at which the endpoint is located;
obtain feet of perpendicular from the four endpoints to the respective opposite end straight lines in sequence; and
determine, in response to any of the feet of perpendicular being located within the skeleton lines in the skeleton line pair, that the interweaving area exists between the two skeleton lines in the skeleton line pair.

In a possible implementation, the interweave pair obtaining module 1730 is configured to:
obtain respective inclination angles of the two skeleton lines in the skeleton line pair based on the position information of the two skeleton lines in the skeleton line pair; and
determine, in response to the respective inclination angles of the two skeleton lines in the skeleton line pair being the same, and extension lines of the two skeleton lines in the skeleton line pair not intersecting, that the two skeleton lines in the skeleton line pair are parallel.

To sum up, according to technical solutions provided in the embodiments of this application, for the circuit layout in which the CPW lines are deployed, the position information of the skeleton lines of the CPW lines is determined based on the position information of the CPW lines corresponding to the circuit layout, and then based on the position information of the skeleton lines of the CPW lines, interweave pairs formed by the skeleton lines that have an impact on the air bridge deployment are determined from the skeleton lines. Then, the air bridges are deployed based on the interweave pair, so that in the interweaving area of the interweave pair, the air bridges on the two skeleton lines are arranged in a staggered manner, and a distance between the air bridges on the two skeleton lines of the interweave pair is maximized, thereby reducing impacts between the air bridges on different CPW lines, and improving a success rate of subsequent circuit preparation.

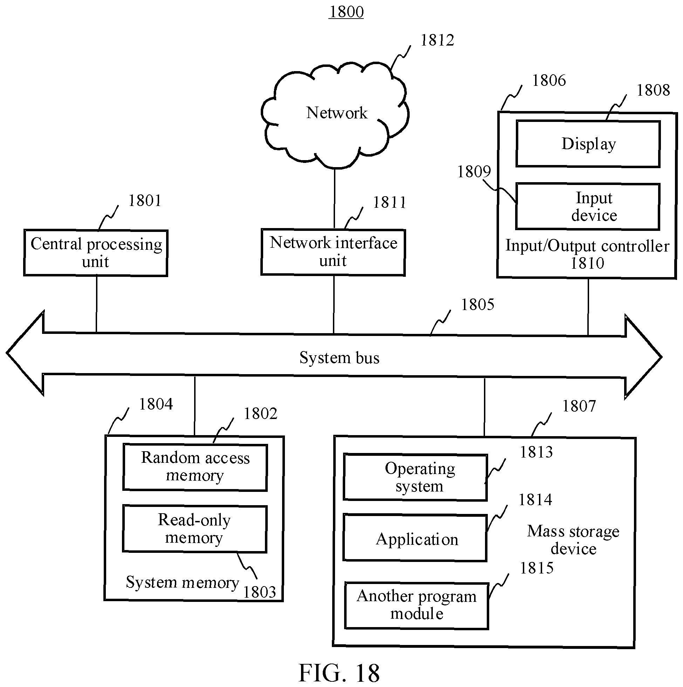

FIG. 18 is a block diagram of a structure of a computer device according to an embodiment of this application. The computer device is configured to implement the air bridge deployment method in a circuit layout provided in the foregoing embodiments. Specifically,
The computer device 1800 includes a central processing unit (CPU) 1801, a system memory 1804 including a random access memory (RAM) 1802 and a read-only memory (ROM) 1803, and a system bus 1805 connecting a system memory 1804 and the central processing unit 1801. The computer device 1800 further includes a basic input/output (I/O) system 1806 assisting in transmitting information between components in the computer, and a mass storage device 1807 configured to store an operating system 1813, an application 1814, and another program module 1815.

The basic input/output system 1806 includes a display 1808 configured to display information and an input device 1809 such as a mouse or a keyboard configured to input information by a user. The display 1808 and the input device 1809 are both connected to the central processing unit 1801 by using an input/output controller 1810 connected to the system bus 1805. The basic input/output system 1806 may further include the input/output controller 1810 to be configured to receive and process input from a plurality of other devices such as a keyboard, a mouse, and an electronic stylus. Similarly, the input/output controller 1810 further provides output to a display screen, a printer, or another type of output device.

The mass storage device 1807 is connected to the central processing unit 1801 by using a mass storage controller (not shown) connected to the system bus 1805. The mass storage device 1807 and a computer-readable medium associated with the mass storage device provide non-volatile storage to the computer device 1800. That is, the mass storage device 1807 may include a computer-readable medium (not shown) such as a hard disk or a compact disc ROM (CD-ROM) drive.

In general, the computer-readable medium may include a computer storage medium and a communication medium. The computer storage medium includes volatile and non-volatile media, and removable and non-removable media implemented by using any method or technology used for storing information such as computer-readable instructions, data structures, program modules, or other data. The computer storage medium includes a RAM, a ROM, an erasable programmable ROM (EPROM), an electrically erasable programmable ROM (EEPROM), a flash memory or another solid-state memory technology, a CD-ROM, a digital versatile disc (DVD) or another optical memory, a tape cartridge, a magnetic cassette, a magnetic disk memory, or another magnetic storage device. Certainly, a person skilled in the art may know that the computer storage medium is not limited to the foregoing several types. The system memory 1804 and the mass storage device 1807 may be collectively referred to as a memory.

According to the embodiments of this application, the computer device 1800 may further be connected, through a network such as the Internet, to a remote computer on the network to run. To be specific, the computer device 1800 may be connected to a network 1812 by using a network interface unit 1811 connected to the system bus 1805, or may be connected to another type of network or a remote computer system (not shown) by using a network interface unit 1811.

In an exemplary embodiment, a chip product is further provided. The chip product includes CPW lines. An interweave pair exists in skeleton lines of the CPW lines, and an interweaving area exists in the interweave pair. The interweaving area is an area at which the air bridge deployment on two skeleton lines in the interweave pair affects each other. Air bridges on the two skeleton lines in the interweave pair are arranged in a staggered manner in the interweaving area.

The air bridges in the circuit layout of the foregoing chip product can be deployed according to the foregoing air bridge deployment method in the circuit layout of this application.

In an exemplary embodiment, a computer-readable storage medium is further provided, having a computer program stored therein, the computer program, when executed by a processor, implementing the foregoing air bridge deployment method in a circuit layout.

The computer-readable storage medium may include: a read-only memory (ROM), a random access memory (RAM), a solid-state drive (SSD), an optical disc, or the like. The random access memory may include a resistance random access memory (ReRAM) and a dynamic random access memory (DRAM).

In an exemplary embodiment, a computer program product is further provided, including a computer program. The computer program is stored in a computer-readable storage medium. A processor of a computer device reads the computer program from the computer-readable storage medium, and the processor executes the computer instructions, so that the computer device implements the foregoing air bridge deployment method in a circuit layout.

"Plurality of" mentioned in the specification means two or more. The term "and/or" describes an association relationship between associated objects and indicates that three relationships may exist. For example, A and/or B may indicate the following three cases: Only A exists, both A and B exist, and only B exists. The character "/" in this specification generally indicates an "or" relationship between the associated objects.

The foregoing descriptions are merely exemplary embodiments of this application, but are not intended to limit this application. Any modification, equivalent replacement, or improvement made within the spirit and principle of this application shall fall within the protection scope of this application.

## Claims

1. An air bridge deployment method in a circuit layout, executable by a computer device, the method comprising:
obtaining position information of skeleton lines of coplanar waveguide (CPW) lines based on position information of the CPW lines in the circuit layout, each of the skeleton lines being a center line of a respective CPW line;
obtaining an interweave pair from the skeleton lines of the CPW lines based on the position information of the skeleton lines of the CPW lines, the interweave pair comprising two interweaved skeleton lines; and
deploying air bridges on the circuit layout along the skeleton lines, and the air bridges on the two skeleton lines in the interweave pair being arranged in a staggered manner.

2. The method according to claim 1, wherein deploying the air bridges on the circuit layout comprises:
obtaining a first endpoint of a first skeleton line in the interweave pair, a vertical line passing through the first endpoint and perpendicular to a second skeleton line intersecting the second skeleton line, and the first skeleton line and the second skeleton line being the two skeleton lines in the interweave pair; and
deploying the air bridges in a staggered manner at a same interval along the first skeleton line and the second skeleton line respectively based on the first endpoint and an intersection between the vertical line and the second skeleton line.

3. The method according to claim 2, wherein deploying the air bridges in the staggered manner at the same interval along the first skeleton line and the second skeleton line respectively based on the first endpoint and the intersection between the vertical line and the second skeleton line comprises:
taking a position of the first endpoint as a deployment position of an air bridge, and deploying the air bridges in sequence at a first interval along the first skeleton line; and
taking a position of the intersection as a midpoint between two adjacent air bridges, and deploying the air bridges in sequence at the first interval along the second skeleton line.

4. The method according to claim 2, wherein deploying the air bridges in the staggered manner at the same interval along the first skeleton line and the second skeleton line respectively based on the first endpoint and the intersection between the vertical line and the second skeleton line comprises:
offsetting half of a second interval along the first skeleton line starting from the first endpoint, to obtain a first deployment position;
taking the first deployment position as a deployment position of an air bridge, and deploying the air bridges in sequence at the second interval along the first skeleton line; and
taking a position of the intersection as a deployment position of an air bridge, and deploying the air bridges in sequence at the second interval along the second skeleton line.

5. The method according to any one of claims 1 to 4, wherein obtaining the interweave pair from the skeleton lines of the CPW lines based on the position information of the skeleton lines of the CPW lines comprises:
traversing and obtaining a skeleton line pair in the skeleton lines of the CPW lines; and
determining the skeleton line pair as the interweave pair in response to a positional relationship between the two skeleton lines in the skeleton line pair satisfying an interweaving condition.

6. The method according to claim 5, wherein the interweaving condition comprises at least one of:
the two skeleton lines in the skeleton line pair being parallel;
a distance between the two skeleton lines in the skeleton line pair being within a specified distance range; and
an interweaving area existing between the two skeleton lines in the skeleton line pair.

7. The method according to claim 5 or 6, wherein traversing and obtaining the skeleton line pair in the skeleton lines of the CPW lines comprises:
traversing and obtaining the skeleton line pair formed by straight line segments in the skeleton lines of the CPW lines.

8. The method according to any one of claims 5 to 7, wherein before determining the skeleton line pair as the interweave pair in response to the positional relationship between the two skeleton lines in the skeleton line pair satisfying the interweaving condition, the method further comprises:
detecting whether the two skeleton lines in the skeleton line pair are parallel;
detecting, in response to the two skeleton lines in the skeleton line pair being parallel, whether the distance between the two skeleton lines in the skeleton line pair is within the specified distance range;
detecting, in response to the distance between the two skeleton lines in the skeleton line pair being within the specified distance range, whether the interweaving area exists between the two skeleton lines in the skeleton line pair; and
determining, in response to the interweaving area existing between the two skeleton lines in the skeleton line pair, that the positional relationship between the two skeleton lines in the skeleton line pair satisfies the interweaving condition.

9. The method according to claim 8, wherein detecting whether the interweaving area exists between the two skeleton lines in the skeleton line pair comprises:
determining four endpoints of the two skeleton lines in the skeleton line pair in sequence;
obtaining an opposite end straight line corresponding to each of the four endpoints, the opposite end straight line being a straight line obtained by extending a skeleton line, other than a skeleton line at which the endpoint is located, in the two skeleton lines in the skeleton line pair;
obtaining feet of perpendicular from the four endpoints to the respective opposite end straight lines in sequence; and
determining, in response to any of the feet of perpendicular being located within the skeleton lines in the skeleton line pair, that the interweaving area exists between the two skeleton lines in the skeleton line pair.

10. The method according to claim 8 or 9, wherein detecting whether the two skeleton lines in the skeleton line pair are parallel comprises:
obtaining respective inclination angles of the two skeleton lines in the skeleton line pair based on the position information of the two skeleton lines in the skeleton line pair; and
determining, in response to the respective inclination angles of the two skeleton lines in the skeleton line pair being the same and extension lines of the two skeleton lines in the skeleton line pair not intersecting, that the two skeleton lines in the skeleton line pair are parallel.

11. An air bridge deployment apparatus in a circuit layout, comprising:
a second position obtaining module, configured to obtain position information of skeleton lines of coplanar waveguide (CPW) lines based on position information of the CPW lines in the circuit layout, each of the skeleton lines being a center line of a respective CPW line;
an interweave pair obtaining module, configured to obtain an interweave pair from the skeleton lines of the CPW lines based on the position information of the skeleton lines of the CPW lines, the interweave pair comprising two interweaved skeleton lines; and
an air bridge deploying module, configured to deploy air bridges on the circuit layout along the skeleton lines, and the air bridges on the two skeleton lines in the interweave pair being arranged in a staggered manner.

12. A computer device, comprising a processor and a memory, the memory having a computer program stored therein, and the processor being configured to execute the computer program to implement the method according to any one of claims 1 to 10.

13. A computer-readable storage medium, having a computer program stored therein, the computer program being loaded and executed by a processor to implement the method according to any one of claims 1 to 10.

14. A computer program product, comprising a computer program, the computer program being loaded and executed by a processor to implement the method according to any one of claims 1 to 10.

15. A chip product, comprising:
CPW lines,
an interweave pair existing in skeleton lines of the CPW lines, and air bridges on two skeleton lines in the interweave pair being arranged in a staggered manner.
